# EUROPEAN PATENT APPLICATION

(11) **EP 4 811 632 A1**
(43) Date of publication of application: **23.09.2026**
(21) Application number: 25305369.8
(22) Date of filing: 18.03.2025
(51) Int. Cl.: H02M 1/08, H03K 17/0412

(54) **POWER CONVERTER AND METHOD OF OPERATING A POWER CONVERTER**

(71) Applicant: ALSTOM Holdings, 93400 Saint-Ouen-sur-Seine (FR)
(72) Inventor: Sir, Michal, 8610 Uster (CH); SOTIRIOU, Sotirios, 8052 Zürich (CH); VON ARX, Jan Simon David, 8105 Regensdorf (CH)
(74) Representative: Brunotte, Joachim Wilhelm Eberhard

(57) **Abstract**

The invention relates to a power converter (11) comprising a power semiconductor switch (1) with insulated gate (13) for repeatedly switching on and off a power current that flows through the power semiconductor switch (1), a gate driver circuit (12; 12a) adapted to generate a gate charging current for charging the gate (13) and to generate a gate discharging current for discharging the gate (13) and a controller (20) adapted to control the gate driver circuit (12; 12a). The gate driver circuit (12; 12a) comprises a first and a second controllable semiconductor switch (23, 24) that are connected in series to each other to form a switch series connection and that are individually controllable by the controller (20). The gate driver circuit (12; 12a) comprises an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end. The gate driver circuit (12; 12a) comprises an inductance (29), wherein an intermediate connection of the switch series connection between the first and second controllable semiconductor switch (23, 24) is connected to the gate (13) via the inductance (29). In order to perform a charging process of charging the gate (13), the controller (20) is adapted to repeatedly switch on and switch off each of the first and second controllable semiconductor switches (23, 24), thereby realizing a charging switching pattern and thereby generating a charging current flowing from the intermediate connection to the gate (13), wherein only one of the first and second controllable semiconductor switches (23, 24) may be on at each time during the charging process.

## Description

The invention relates to a power converter and to a method of operating a power converter. Furthermore, the invention relates to power electronics devices, in particular power converters, that utilize power semiconductor switches for switching on and off a power current that flows - during operation and when the power semiconductor switch is switched on - through the power semiconductor switch. The invention is especially related to power semiconductor switches having an insulated gate as control electrode. Examples are FETs (field-effect transistors), especially MOSFETs (metal-oxide-semiconductor field-effect transistors, for example the semiconductor material being SiC), IGBTs (insulated-gate bipolar transistors), thyristors in general, GTOs (gate turn-off thyristors) and IGCTs (integrated-gate commutated thyristors).

In many cases, and especially with certain embodiments of the invention, power converters comprise at least one branch, which comprises two power semiconductor switches that are electrically connected in series to each other. The branch is therefore a series connection comprising the two power semiconductor switches. Typically, one end of the branch is connected to a first voltage potential and the other end of the branch is connected to a second voltage potential, wherein the two voltage potentials are potentials of a constant or nearly that may be subject to fluctuations, for example because the is generated by the power converter or by a second power converter connected to the power converter. In addition, an intermediate connection of the switch series connection between the first and second power semiconductor switch is connected or is to be connected to a device, such as a traction motor of a rail vehicle. By alternatingly switching on and off the two power semiconductor switches, depending on the kind of operation mode, either a direct current fed from the branch's ends is converted into an alternating current at the intermediate connection (in case of the traction motor causing traction of the rail vehicle), or an alternating current at the intermediate connection is converted into a direct current (in case the traction motor is operating in dynamic braking mode). Therefore, the invention is not restricted to operating a single power semiconductor switch, but can be applied to a power converter having at least one branch.

For switching on and off a power semiconductor switch that comprises an insulated gate, the gate needs to be charged and discharged. Therefore, electric currents are required for charging and discharging the gate. Typically, these gate currents are significantly smaller than the power current. There are different kinds of the gate driver circuit that generate the charging and discharging current. Depending on the way the power semiconductor switch is operated, electric energy losses and resulting power losses within the gate driver circuit need to be considered and reduced at least to some extent. Resistive electric energy losses produce heat that is to be dissipated into the environment. In particular if the switching frequency is high, such as in the medium frequency region in the magnitude order of 1 kHz, for example in a range having its minimum value for example at 100 Hz and its maximum value for example at 5 kHz or 10 kHz, or even higher (e.g. 15 kHz or 20 kHz), power losses are significant. Medium switching frequency is required in case of one exemplary application of the invention, the medium frequency DC/DC (direct current/direct current) converter.

Power losses are particularly problematic if the gate driver circuit is realized as a printed circuit board (PCB). The advantage of the PCB is that the gate driver circuit can be arranged close to the driven semiconductor switch, here the power semiconductor switch with insulated gate, thereby achieving an optimized switching performance of the driven semiconductor device. Power losses within the driver board may therefore be a limiting factor for realizing converters with high performance, especially converters operating with medium frequency. This is especially true in the technical field of traction converters for providing traction of rail vehicles. Improving the cooling of the gate driver circuit in case of a PCB is restricted, particularly due to high voltage insulation requirements.

It is an object of the present invention to provide a power converter and method of operating a power converter involving reduced power losses of the gate driver circuit compared to known solutions, in particular compared to solutions comprising a gate driver circuit having a discrete resistive element connected in series to the gate through which the gate current flows during charging and discharging of the gate.

A power converter is proposed that comprises - as part of the gate driver circuit - a first and a second controllable semiconductor switch that are connected in series to each other to form a switch series connection. The first controllable semiconductor and the second controllable semiconductor are individually controllable by a controller of the gate driver circuit. In particular if the switching frequency of the controllable semiconductor switches is higher than 1 MHz, for example being in the range from 10 to 15 MHz for operating a power semiconductor at a switching frequency in the medium frequency range, the semiconductor material of the controllable semiconductor switches may be GaN (gallium nitride). The gate driver circuit comprises an electric energy source, and therefore a power source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end. Furthermore, the gate driver circuit comprises an inductance, wherein an intermediate connection of the switch series connection between the first and second controllable semiconductor switch is connected to the gate via the inductance. The inductance can be realized by a single inductive element (an inductor) or by a plurality of inductive elements (inductors). for example, the inductance of a gate driver circuit for controlling the gate of a MOSFET power semiconductor switch of a rail traction power converter that is to be switched with a frequency in the medium frequency region may be in a range starting from (lower range limit) at least 0.2µH, preferably from 0.5 µH, and having its upper range limit at a maximum of 5 µH, preferably of 2 µH.

In order to perform a charging process of charging the gate (for switching on the power semiconductor switch), the controller repeatedly switches on and switches off each of the first and second controllable semiconductor switches, thereby realizing a charging switching pattern and thereby generating a charging current flowing from the intermediate connection to the gate. Only one of the first and second controllable semiconductor switches may be on at each time during the charging process. In addition or alternatively, in order to perform a discharging process of discharging the gate, the controller repeatedly switches on and switches off each of the first and second controllable semiconductor switches, thereby realizing a discharging switching pattern and thereby generating a discharging current flowing from the gate to the intermediate connection, wherein only one of the first and second controllable semiconductor switches may be on at each time during the discharging process.

As mentioned, the intermediate connection is electrically connected to the gate via the inductance. Therefore, not only switching on and off the first and second controllable semiconductor switches, but also the inductance (namely the size of the inductance) determines the gate charging current or the gate discharging current. In particular when the first controllable semiconductor switch is switched on for the first time during the gate charging process, the start and rise of the gate charging current is determined by the inductance. In this phase of the gate charging process, the inductance is charged with energy. In particular while the gate charging current flows, the first semiconductor switch is switched off and the second semiconductor switch is switched on. Due to the energy stored by the inductance, and therefore determined by the inductance, the gate a charging current continues flowing to the gate. In corresponding manner, the inductance influences and determines the gate discharging current during the process of discharging the gate if the first and second controllable semiconductor switches are switched on and off repeatedly.

Preferably, the switching pattern and the inductance are adapted to each other to produce a continuous charging current during the charging process until the switching state of the power semiconductor switch is changed by the charging process. In particular at the beginning of the gate charging process, the sum of the on-times (the time intervals while the respective controllable semiconductor switch is on) is larger for the first semiconductor switch than for the second semiconductor switch and, at the beginning of the gate discharging process, the sum of the on-times is larger for the second semiconductor switch than for the first semiconductor switch during the gate discharging process (provided that the first semiconductor switch is the switch that is to be switched on in order to cause the gate charging current to flow). Furthermore, in particular, the duty cycle of the first switch (i.e. the on-time divided by the time period of switching on and off the first switch and the second switch once, which is therefore the time period of one switching cycle) is increasing as the ratio of the gate voltage to the power supply voltage.

One advantage of the described procedure of repeatedly switching on and off the first and second controllable semiconductor switches and of using the inductance is the fact that the dynamic behavior (corresponding to the mathematical function describing its development over time) of the gate charging current and/or of the gate discharging current can be controlled by the switching pattern. For example, the size of the effective voltage that produces the gate charging current or the gate discharging current depends on the switching pattern. In other words, by adapting the switching pattern, the size of the effective voltage can be adjusted. The effective voltage is the mean voltage determined over several switching circles of switching on and off the semiconductor switches between the gate and the reference voltage potential of the gate driver circuit, typically the voltage potential at the source/emitter of the power semiconductor switch.

Furthermore, the procedure makes the charging/discharging current independent from the gate voltage of the controlled power semiconductor.

In addition, power losses caused by a discrete resistive element, that is connected in conventional gate driver circuits in series to the gate and through which the gate charging current and the gate discharging current flows, are reduced, since such a discrete resistive element is not required and is omitted. The described principle of having the switching pattern in combination with the inductance enables controlling the gate charging and gate discharging processes without such a resistive element.

The above proposal results in a proposal of power converter comprising:
- a power semiconductor switch with insulated gate for repeatedly switching on and off a power current that flows through the power semiconductor switch,
- a gate driver circuit adapted to generate a gate charging current for charging the gate and to generate a gate discharging current for discharging the gate,
- a controller adapted to control the gate driver circuit
wherein
- the gate driver circuit comprises a first and a second controllable semiconductor switch that are connected in series to each other to form a switch series connection and that are individually controllable by the controller,
- the gate driver circuit comprises an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end,
- the gate driver circuit comprises an inductance, wherein an intermediate connection of the switch series connection between the first and second controllable semiconductor switch is connected to the gate via the inductance,
- in order to perform a charging process of charging the gate, the controller is adapted to repeatedly switch on and switch off each of the first and second controllable semiconductor switches, thereby realizing a charging switching pattern and thereby generating a charging current flowing from the intermediate connection to the gate, wherein only one of the first and second controllable semiconductor switches may be on at each time during the charging process, and/or
- in order to perform a discharging process of discharging the gate, the controller is adapted to repeatedly switch on and switch off each of the first and second controllable semiconductor switches, thereby realizing a discharging switching pattern and thereby generating a discharging current flowing from the gate to the intermediate connection, wherein only one of the first and second controllable semiconductor switches may be on at each time during the discharging process.

In addition, a corresponding method is proposed of operating a power converter, the power converter comprising:
- a power semiconductor switch with insulated gate that is repeatedly switched on and off to switch a power current which flows through the power semiconductor switch,
- a gate driver circuit that generates a gate charging current for charging the gate and generates a gate discharging current for discharging the gate,
- wherein the gate driver circuit is controlled by a controller of the power converter to charge and discharge the gate, thereby changing the switching state of the semiconductor switch from on to off or from off to on,
wherein the method comprises:
- by using the controller, individually controlling a first and a second controllable semiconductor switch of the gate driver circuit, that are connected in series to each other and therefore form a switch series connection,
- providing electric energy for charging and discharging the gate from an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end,
- conducting the gate charging current for charging the gate and/or the gate discharging current for discharging the gate through a current path between an intermediate connection of the switch series connection and the gate, which intermediate connection is arranged between the first and second controllable semiconductor switch,
- in order to perform a charging process of charging the gate, the controller repeatedly switches on and switch off each of the first and second controllable semiconductor switches, thereby realizing a charging switching pattern and thereby generating a charging current flowing from the intermediate connection to the gate, wherein only one of the first and second controllable semiconductor switches is on at each time during the charging process, and/or
- in order to perform a discharging process of discharging the gate, the controller repeatedly switches on and switch off each of the first and second controllable semiconductor switches, thereby realizing a discharging switching pattern and thereby generating a discharging current flowing from the gate to the intermediate connection, wherein only one of the first and second controllable semiconductor switches is on at each time during the discharging process.

There are several embodiments and further developments of the power converter and of the method of operating the power converter.

According to one embodiment, the controller is combined with a switching pattern storage (for example realized by an FPGA, a field programmable gate array, or by another type of PLD, programmable logic device) in which at least one switching pattern of a timing of switching on and switching off the first and second controllable semiconductor switches is stored. In this case, the controller is adapted to access the switching pattern storage and is adapted to repeatedly switch on and switch off each of the first and second controllable semiconductor switches according to the accessed charging switching pattern or accessed discharging pattern. According to a corresponding embodiment of the method, the controller accesses a switching pattern storage, in which at least one switching pattern of a timing of switching on and switching off the first and second controllable semiconductor switches is stored, and repeatedly switches on and switches off each of the first and second controllable semiconductor switches according to the accessed charging switching pattern or accessed discharging pattern.

The at least one stored switching pattern has the advantage that the controller does not require a closed loop control, although the accessed switching pattern may optionally be scaled and/or altered depending on the size of the gate charging current in case of charging the gate or depending on the size of the gate discharging current in case of discharging the gate. For example, the size may be defined by a predetermined value of the current. If a plurality of different switching patterns is stored in the storage, one of these switching patterns can be selected and accessed to perform the charging process or the discharging process. Furthermore, at least one additional switching pattern can be added later to the storage, so that the number of different options of operating the gate driver circuit can be increased.

According to a different embodiment, the controller comprises a closed-loop control
- with a measurement input adapted to repeatedly receive a measurement value of the gate charging current or of the gate discharging current and
- with a reference input adapted to receive a reference value of a current,
wherein the closed-loop control is adapted to control repeatedly switching on and switching off each of the first and second controllable semiconductor switches so that the gate charging current or the gate discharging current is regulated to the reference value. According to a corresponding embodiment of the method, a closed-loop control of the controller
- repeatedly receives a measurement value of the gate charging current or of the gate discharging current and
- receives a reference value of a current,
wherein the closed-loop control controls repeatedly switching on and switching off each of the first and second controllable semiconductor switches so that the gate charging current or the gate discharging current is regulated to the reference value.

Such a closed-loop control is a particularly flexible and stable way of realizing the controller. In practice, the gate current may be increased by the controller, if a difference of the measured value to the reference value indicates an increase, by increasing the ratio of the on-times of the first controllable semiconductor switch to the on-times of the second controllable semiconductor switch. This applies to the example described above in which the first semiconductor switch is the switch that is to be switched on in order to cause the gate charging current to flow.

The closed-loop control may be, for example, realized as a PI (Proportional, Integral) regulator, or as a hysteresis regulator. In addition or alternatively, the controller may comprise an FPGA (field programmable gate array) or another type of PLD (programmable logic device) that provides the reference value of the current in form of an analogue signal and/or provides a clock signal for the control of the switching on and off of the first and second controllable semiconductor switches and/or controls switching on at least one of the steady state switches (see below). The gate current as a function of time may be programmed/programmable. This may be realized by pre-defining and programming the reference value as a function of time. The terms "programmed" and "programmable" are equivalent to the reference value being stored in a computer-accessible data storage. When the control of the controllable semiconductor switches is performed, a program accesses the reference value as a function of time as stored in the data storage. this means that the same hardware can be used for performing gate charging and discharging processes according to different pre-defined gate currents as functions of time.

In case of the closed-loop control, the number of the actions of switching on and off the first and second controllable semiconductor switches during the process of charging or discharging the gate may be at least ten, in particular at least one hundred and may be at least five hundred. A high number of switching actions enables the controller to regulate the gate current fast and with a small deviation to the reference value.

According to a further embodiment, the power converter comprises a first steady state switch that is connected to a connection from the inductance to the gate and is connected to the first voltage potential. If the first steady state switch is open, the connection from the inductance to the gate and thereby the gate is not directly connected to the first voltage potential via the first steady state switch. If the first steady state switch is closed, the gate is directly connected via the first steady state switch to the first voltage potential. In addition, the gate driver circuit is adapted to switch on the first steady state switch in a first switching state of the power semiconductor switch, wherein the first switching state is the state the power semiconductor switch assumes when the gate is at the first voltage potential. According to a corresponding embodiment of the method of operating the power converter, the first steady state switch is switched on in the first switching state. In particular, the first voltage potential is the higher potential compared to the second voltage potential.

In addition or alternatively, the power converter comprises a second steady state switch that is connected to a connection from the inductance to the gate and is connected to the second voltage potential. If the second steady state switch is open, the connection from the inductance to the gate and thereby the gate is not directly connected to the second voltage potential via the second steady state switch. If the second steady state switch is closed, the gate is directly connected via the second steady state switch to the second voltage potential. In addition, the gate driver circuit is adapted to switch on the second steady state switch in a second switching state of the power semiconductor switch, wherein the second switching state is the state the power semiconductor switch assumes when the gate is at the second voltage potential. According to a corresponding embodiment of the method of operating the power converter, the second steady state switch is switched on in the second switching state. In particular, the second voltage potential is the lower potential compared to the first voltage potential.

The advantage of the first and second steady state switches is the fact that the gate has a low impedance connection to the respective voltage potential if the respective steady status which is closed. Therefore, effects of current or voltage transients in the load path of the controlled power semiconductor switch (such as affecting the electric state of the drain/collector and/or of the source/emitter) can be avoided. For example, a current or voltage transient at the drain/collector might switch on the power semiconductor switch unintentionally if there is no second steady state switch or if the second steady state switch is not closed. In addition, the stead state switch being switched on prevents unintentional switching off the power semiconductor switch when a current or voltage transient in the load path occurs, while the power semiconductor switch is on.

There are several options how the control of switching on the steady state switch or steady-state switches can be performed. The control may be performed by the same controller that controls the first and/or second controllable semiconductor switch, although the principles of performing the control are different. Alternatively, the first and/or second steady state switch may be controlled by a different, second controller. It is also possible that the first and second steady state switches are controlled by different controllers, so that the first steady state switch is controlled by a second controller and the second steady status which is controlled by a third controller.

The process of controlling the steady state switch(es) may be based on a measurement or on measurements of at least one of the following quantities:
- the gate voltage of the controlled power semiconductor switch, such as the voltage between the gate and the source or emitter; for example, the respective steady state switch may be switched on if the gate voltage has reached a predetermined threshold value; as an alternative, a different voltage that depends on the gate voltage may be used for the process of controlling;
- the time elapsed from the beginning of the charging process or discharging process; for example, when a minimum time has elapsed, the respective steady status which is switched on; in particular if the first voltage potential is the higher voltage potential and if the power semiconductor switch is on when the gate is at the first voltage potential or at least at a certain fraction of for example 90% of the first voltage potential, the first steady state switch is switched on when the minimum time since the beginning of the gate charging process has elapsed;
- the gate charging current or gate discharging current; for example, a drop of the charging current or discharging current may trigger switching on the respective steady state switch; this is based on the idea that the charging current or discharging current will drop at the end of the gate charging process or gate discharging process;
- if there is a free-wheeling diode anti-parallel to the steady state switch, which may be the case for any of the embodiments of controlling the steady state switch(es), a current through the free-wheeling diode may trigger switching on the respective steady state switch.

If any of the mentioned electric quantities is used for the controlling process, the respective quantity is repeatedly measured, directly or indirectly, and the respective measurement value is an input to the steady state switch controller. In order to increase safety that the respective steady state switch is switched on as intended, more than one of the mentioned electric quantities may be measured. For example, the gate voltage and the charging current may be measured: If the gate voltage has reached a predetermined voltage value and if a drop of the charging current is detected, the first steady state switch is switched on. In any case, the controller that controls the first and/or second steady state switch may be realized as a FPGA (field programmable gate array) or as another type of PLD (programmable logic device).

As an alternative, the first and/or second steady state switch can be omitted and, instead, a diode can be arranged to connect the connection from the inductance to the gate, and thereby the gate, to the first/second voltage potential. However, the use of the steady state switch(es) is preferred, since this allows currents to flow through the switch in both directions, so that the voltage potential at the gate is kept safely at the first or second voltage potential.

Aspects, embodiments and examples of the invention will be described with reference to the attached figures which show:
- Fig. 1: an example of a power converter comprising three branches, wherein in each branch two power semiconductor switches are connected in series to each other,
- Fig. 2: a power semiconductor switch, the gate of which is connected to a gate driver circuit,
- Fig. 3: a circuit diagram showing a first embodiment of the arrangement shown in Fig. 2,
- Fig. 4: a circuit diagram showing a second embodiment of the arrangement shown in Fig. 2,
- Fig. 5: a block diagram for illustrating the control of switches of the first embodiment of Fig. 3 or of the second embodiment of Fig. 4,
- Fig. 6: the development over time of several signals and electric quantities of a first variant of the control illustrated in Fig. 5,
- Fig. 7: the development over time of several signals and electric quantities of a second variant of the control illustrated in Fig. 5,

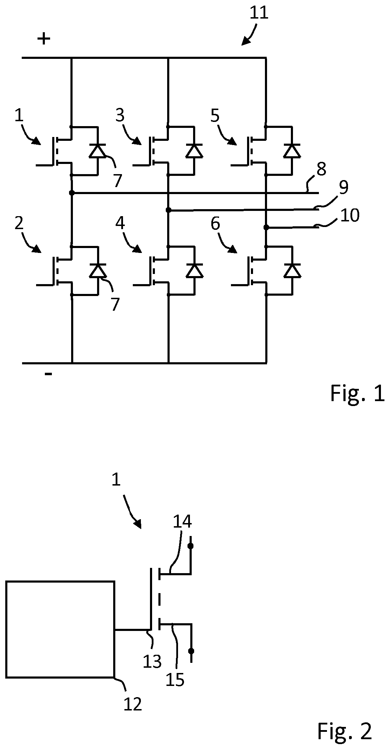

Fig. 1 shows a power converter 11 as an example of a power converter according to the invention. The power converter 11 comprises three branches, wherein in each branch two power semiconductor switches 1, 2; 3, 4; 5, 6 are connected in series to each other. One end of each branch is connected to a first, positive voltage potential and the other end of each branch is connected to a second, negative or lower voltage potential as indicated by plus and minus signs. In each branch, an intermediate connection of the switch series connection between the two power semiconductor switches 1, 2; 3, 4; 5, 6 is connected to an alternating current line 8, 9, 10. In this example, a free-wheeling diode 7 is connected in anti-parallel fashion to each of the power semiconductor switches 1 to 6. In Fig. 1, reference numeral 7 is only linked to power semiconductor switches 1 and 2. By alternatingly switching on and off the two power semiconductor switches 1, 2; 3, 4; 5, 6 in each branch with a phase shift between the three branches, depending on the kind of operation mode, either a direct current fed from the branch's ends is converted into a three-phase alternating current in the alternating current lines 8, 9, 10 (in case of a traction motor being connected to the alternating current lines 8, 9, 10 causing traction of the rail vehicle), or an three-phase alternating current in the alternating current lines 8, 9, 10 is converted into a direct current (in case the traction motor is operating in dynamic braking mode).

Another example of a power converter according to the invention is a medium frequency converter that comprises a plurality of power semiconductor switches. Fig. 2 shows one power semiconductor switch 1, which may be the switch 1 of Fig. 1 or a power semiconductor switch of a different power converter. The power semiconductor switch 1 shown in Fig. 2 comprises an insulated gate 13 as control electrode for switching on and off the power semiconductor switch 1. Furthermore, the power semiconductor switch 1 is illustrated in this example as a MOSFET comprising a drain 14 and a source 15. However, other types of power semiconductors with insulated gate comprise regions with corresponding electric connections to the outside that are typically named collector instead of drain 14 and emitter instead of source 15.

As schematically shown in Fig. 2, a gate driver circuit 12 is connected to the gate 13 for generating and thereby driving the gate currents for charging and discharging the gate 13.

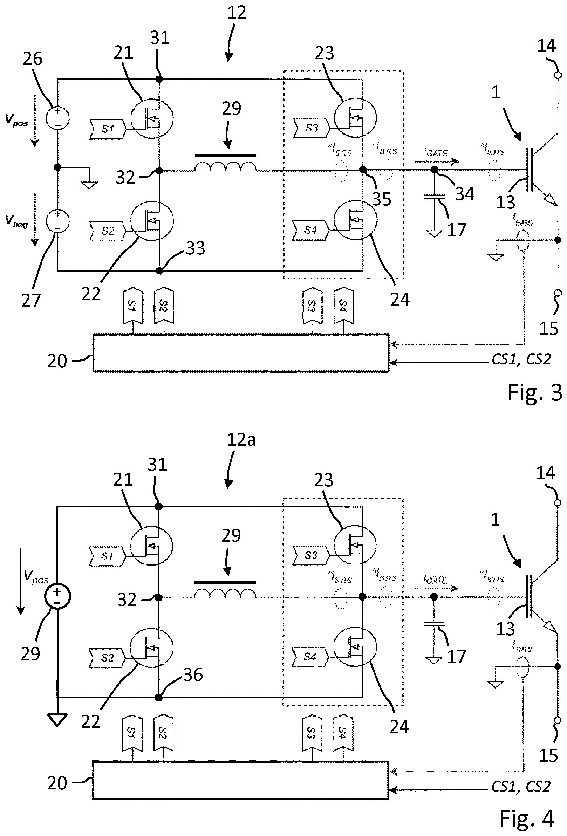

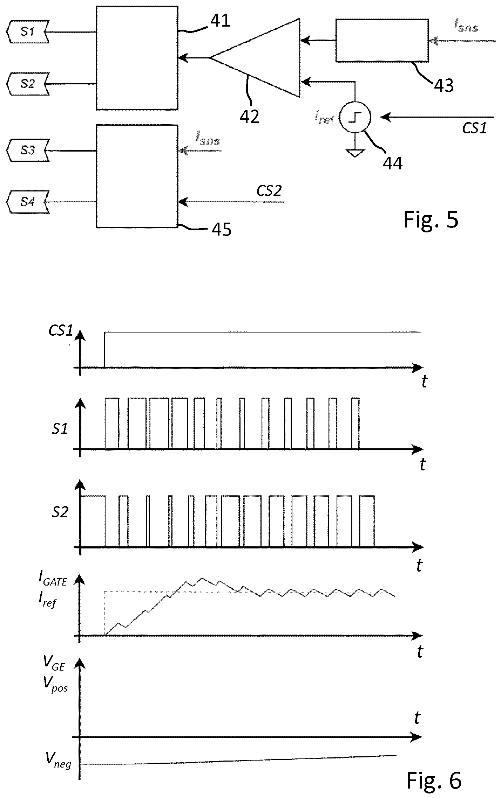

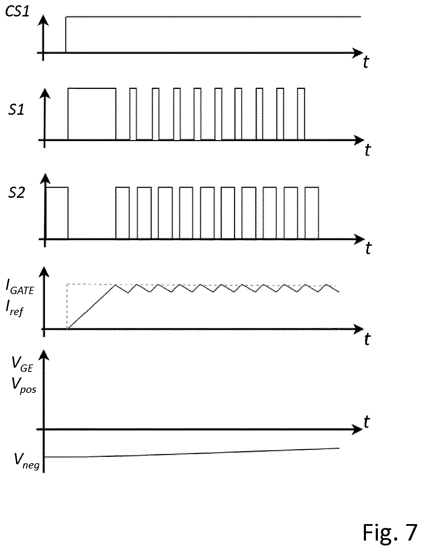

The circuit and block diagram of fig. 3 shows a first embodiment of the arrangement of fig. 2. In this embodiment, there are two power sources 26, 27. Mass or zero potential (in the following only "mass potential") is indicated by a triangle pointing downwards. In the embodiment shown in fig. 3, mass potential is arranged in between the two power sources 26, 27, so that the voltage range that can be used by the gate driver circuit 12 comprises a negative voltage potential. As a result, there is a positive voltage potential at the circuit point 31 shown at the top of the circuit diagram and there is a negative voltage potential at the circuit point 33 at the bottom of the circuit diagram. The voltage between the circuit points 31, 33 is the sum of the voltages produced by the power sources 26, 27. This voltage between the circuit points 31, 33 is also the voltage at the ends of a switch series connection formed by a first controllable semiconductor switch 21 and a second controllable semiconductor switch 22 that are connected in series to each other and that are individually controllable (to be switched on and off) by the controller 20 schematically shown at the bottom of fig. 3. The first controllable semiconductor switch 21 is controlled by a first PWM (pulse width modulation) signal S1, the second controllable semiconductor switch 22 is controlled by a second PWM signal S2. Each of the PWM signals S1 and S2 comprises two signal levels (corresponding to two voltage potentials) as shown in the second and third diagram from the top of fig. 6 and fig. 7. These diagrams show the behavior of the respective PWM signal S1, S2 over time t. When the PWM signal S1, S2 is at the high signal level, the respective controllable semiconductor switch 21, 22 is on and when the PWM signal S1, S2 is at the low signal level, the respective controllable semiconductor switch 21, 22 is off. In the embodiment described here, and also in other embodiments of the gate driver circuit, number of switching actions of switching on and off each of the controllable semiconductor switches 21, 22 is preferably in the range of 10 to 10,000.

An inductance 29 connects a circuit point 32 between the series connection of the first and second controllable semiconductor switch 21, 22 with the gate 13 of the power semiconductor 1 that is to be controlled by the gate driver circuit. The part of the circuit diagram that is enclosed by a dashed rectangular line is optional and is therefore be omitted in some embodiments of the invention. In this case, the inductance 29 is still connected directly to the gate 13. The optional part and its function will be described later.

In the specific embodiment shown in fig. 3 the gate 13 is also connected to mass potential via a capacitance 17, which may be realized by a single capacitor or by a plurality of capacitors that are connected in parallel and/or in series to each other. Such a capacitance between the mass potential and the gate can be provided/used in other embodiments of the gate driver circuit as well and it has the advantage that fluctuations of the gate current are smoothed. Preferably, the capacitance is smaller, in particular smaller by at least one order of magnitude (i.e. at least a factor 10), as the capacitance of the power semiconductor switch between the gate and source/emitter.

When the gate 13 is discharged and a process of charging the gate 13 by using a gate charging current is started, the first controllable semiconductor switch 21 is switched on. You to the self-induction of the inductance 29, the rise of the charging current is delayed and the inductance 29 is charged by electric energy. the fourth diagrams from the top in fig. 6 and fig. 7 show the rise of the gate current I_{GATE} over several cycles of switching on and off the first and second controllable semiconductor switch 21, 22. The details of the different behavior of the gate current I_{GATE} as shown in fig. 6 and fig. 7 will be described later. In any case, the first time interval in which the first controllable semiconductor switch 21 is terminated by switching it off and the second controllable semiconductor switch 22 is switched on. This does not terminate the gate current I_{GATE}, since the inductance 29 maintains the flow of the gate current I_{GATE} into the same direction as before towards the gate 13. The respective electric energy for maintaining the gate current I_{GATE} is taken by discharging the inductance 29. However, the size of the gate current I_{GATE} reduces, as can be seen from the ripples of the gate current I_{GATE} shown in fig. 6 and fig. 7. Then, the second controllable semiconductor switch 22 is switched off and the first controllable semiconductor switch 21 is switched on again.

According to one embodiment, the reference current I_{ref}, which is the target quantity for controlling the semiconductor switches 21, 22 is constant over the time interval of charging the gate. Therefore, the gate charging current I_{GATE} reaches a constant level after a plurality of switching cycles, as shown in fig. 6 and fig. 7. Due to the switching, the gate charging current I_{GATE} still fluctuates. For example, the gate charging process is terminated if the gate voltage V_{GE} reaches a predetermined value, such as the, such as the positive voltage Vₚₒₛ produced by the first power source 26 or close to that voltage. Alternatively, and not limited to the examples described here, the reference current I_{ref} may be varied during the time interval of charging or discharging the gate. In particular, the reference current I_{ref} may be larger at the beginning of the time interval than later during the time interval. The switching performance of the driven semiconductor can be improved in this manner. In addition or alternatively, the reference current I_{ref} can be set dependent on at least one parameter, for example the temperature and the voltage across the power current path of the power semiconductor switch.

The process of discharging the gate in order to switch of the power semiconductor switch 1 can be performed correspondingly. However, the process is started with switching on the second controllable semiconductor switch 22 so that a gate current from the gate 13 through the inductance 29 to the negative voltage potential (for example at the circuit point 33) starts flowing. By repeatedly switching on and off the first and second controllable semiconductor switches 21, 22, the discharging current is controlled and the discharging process may be terminated when the gate voltage V_{GE} reaches a predetermined value, such as the negative voltage V_{neg} produced by the second power source 27 or a value close to zero voltage.

The optional part of the circuit diagram shown in fig. 3 comprises a series connection of two steady-state switches 23, 24. The intermediate circuit point 35 of these steady-state switches 23, 24 is part of the connection between the inductance 29 and the gate 13. It should be noted that there are also embodiments of the gate driver circuit according to the invention which comprises only one of the steady-state switches 23, 24. For example, only the second steady-state switch 24 may be present.

When the power semiconductor switch 1 has been switched on by charging its gate 13, the first steady-state switch 23 is switched on. Thereby, the gate 13 is directly connected to the positive voltage potential at the circuit point 31. Advantages are described above. Consequently, and not only related to the embodiment described here, the first steady-state switch 23 needs to be switched off before the gate 13 is discharged.

When the power semiconductor switch 1 has been switched off by discharging its gate 13, the second steady-state switch 24 is switched on. Thereby, the gate 13 is directly connected to the negative voltage potential at the circuit point 33. Advantages are described above. Consequently, and not only related to the embodiment described here, the second steady-state switch 24 needs to be switched off before the gate 13 is charged.

Fig. 4 shows a circuit diagram and a block diagram of a controller according to a second embodiment of an arrangement with a gate driver circuit 12a that controls a power semiconductor switch 1. Elements having the same function as with the first embodiment shown in fig. 3 are denoted by the same reference sign as in fig. 3. The differences to the first embodiment will be described:
There is only one power source 29 and the mass potential is connected to the negative pole of the power source 29. Therefore, the series connection of the first and second controllable semiconductor switch 21, 22 is connected at its ends to a positive voltage potential at the circuit point 31 (as before) and to the mass potential, for example at the circuit point 36. By discharging the gate 13, the gate voltage V_{GE} cannot become smaller than zero. However, the gate charging and discharging processes can be performed in the same manner as described with reference to fig. 3. When the gate 13 is discharged, the second steady-state switch 24 (in case this option is present) is closed and the gate 13 is therefore reliably kept at mass potential.

Fig. 5 schematically shows an exemplary embodiment of the controller 20. As shown in fig. 3 and fig. 4, the command signals CS1 and CS2 are inputs of the controller 20. The first, and signal CS1 triggers the charging or discharging process. As a result, a reference signal generation device 44 generates the reference current I_{ref}, which is fed to the regulator 42. In addition, the gate current Iₛₙₛ is an input to the controller 20. As shown in fig. 3 and fig. 4 the gate current Iₛₙₛ can be measured at at least one of several points of the circuitry. Some of these points are at the connection between the inductance 29 and the gate 13. However, the gate current Iₛₙₛ can alternatively or in addition be measured at any point of the connection from the source/emitter 15 to the mass potential. Coming back to fig. 5, the gate current Iₛₙₛ is pre-processed by a signal processing device 43 and its output is input to the regulator 42 as well. The signal processing device 43 may amplify the signal representing the gate current Iₛₙₛ and/or may filter the signal to improve its quality. The regulator 42 regulates the gate current to match the reference current I_{ref}. From the corresponding output of the regulator 42, the PWM modulation device 41 generates the PWM signals S1 and S2, according to which the first and second controllable semiconductor switches 21, 22 are switched on and off.

If the option with the first and second steady-state switches 23, 24 is realized, the controller 20, and in this embodiment an evaluation and controlling device 45 of the controller 20, receives the second control signal CS2 which signals that the steady-state switches 23, 24 are to be operated. In addition, the evaluation and controlling device 45 receives the gate current Iₛₙₛ as measured, i.e. continuously receives measurement values of the gate current Iₛₙₛ. Optionally, the evaluation and controlling device 45 also considers the time elapsed since the start of the charging process or of the discharging process when determining when the first steady-state switch 23 is switched on by outputting a control signal S3 (at the end of the gate charging process) and when the second steady-state switch 24 is switched on by outputting a control signal S4 (at the end of the gate discharging process).

There are different ways how the regulator 42 can be implemented. One way is to implement a PI (proportional, integral) regulator or a PID (proportional, integral, differential) regulator. In case of a PI regulator, the behavior of the gate charging current I_{GATE} is shown in fig. 6 in the fourth diagram from the top. There is a small overshoot of the reference current I_{ref} due to the integral part of the PI regulator.

A second way is to implement the regulator as a hysteresis regulator. In this case, there is no overshoot of the reference current I_{ref} as shown in fig. 7.

Fig. 6 and fig. 7 show in the second and third diagram from the top the PWM signals to the first and second controllable semiconductor switches 23, 24. They differ in fig. 6 and fig. 7 due to the different implementation of the regulator 42. It should be noted that fig. 6 and fig. 7 only illustrates the beginning of the charging process. This can be seen from the diagram at the bottom of fig. 6 and fig. 7 which shows that the gate voltage V_{GE} gradually increases from a negative voltage V_{neg} as the starting point of the gate charging process. Therefore, the diagrams in fig. 6 and fig. 7 relate to the embodiment shown in fig. 3.

### List of reference signs

- 1 to 6: power semiconductor switch
- 7: free-wheeling diode
- 8 to 10: alternating current line
- 11: power converter
- 12, 12a: gate driver circuit
- 13: gate
- 14: drain/collector
- 15: source/emitter
- 17: capacitance
- 20: controller
- 21: first controllable semiconductor switch
- 22: second controllable semiconductor switch
- 23: first steady state switch
- 24: second steady state switch
- 26, 27, 28: power source
- 29: inductance
- 31 to 36: circuit points
- 41: PWM modulation device
- 42: regulator
- 43: signal processing device
- 44: reference signal generation device
- 45: evaluation and controlling device
- CS1, CS2: control signals
- S1: PWM signal to first controllable semiconductor switch
- S2: PWM signal to second controllable semiconductor switch
- S3: control signal to first steady state switch
- S4: control signal to second steady state switch

## Claims

1. A power converter (11) comprising:
- a power semiconductor switch (1) with insulated gate (13) for repeatedly switching on and off a power current that flows through the power semiconductor switch (1),
- a gate driver circuit (12; 12a) adapted to generate a gate charging current for charging the gate (13) and to generate a gate discharging current for discharging the gate (13),
- a controller (20) adapted to control the gate driver circuit (12; 12a),
**characterized in that**
- the gate driver circuit (12; 12a) comprises a first and a second controllable semiconductor switch (23, 24) that are connected in series to each other to form a switch series connection and that are individually controllable by the controller (20),
- the gate driver circuit (12; 12a) comprises an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end,
- the gate driver circuit (12; 12a) comprises an inductance (29), wherein an intermediate connection of the switch series connection between the first and second controllable semiconductor switch (23, 24) is connected to the gate (13) via the inductance (29),
wherein
- in order to perform a charging process of charging the gate (13), the controller (20) is adapted to repeatedly switch on and switch off each of the first and second controllable semiconductor switches (23, 24), thereby realizing a charging switching pattern and thereby generating a charging current flowing from the intermediate connection to the gate (13), wherein only one of the first and second controllable semiconductor switches (23, 24) may be on at each time during the charging process, and/or
- in order to perform a discharging process of discharging the gate (13), the controller (20) is adapted to repeatedly switch on and switch off each of the first and second controllable semiconductor switches (23, 24), thereby realizing a discharging switching pattern and thereby generating a discharging current flowing from the gate (13) to the intermediate connection, wherein only one of the first and second controllable semiconductor switches (23, 24) may be on at each time during the discharging process.

2. The power converter (11) of claim 1, wherein the switching pattern and the inductance (29) are adapted to each other to produce a continuous charging current during the charging process until the switching state of the power semiconductor switch (1) is changed by the charging process.

3. The power converter (11) of claim 1 or 2, wherein
- the controller (20) is combined with a switching pattern storage in which at least one switching pattern of a timing of switching on and switching off the first and second controllable semiconductor switches (23, 24) is stored and
- the controller (20) is adapted to access the switching pattern storage and is adapted to repeatedly switch on and switch off each of the first and second controllable semiconductor switches (23, 24) according to the accessed charging switching pattern or accessed discharging pattern.

4. The power converter (11) of one of claims 1 to 3, wherein the controller (20) comprises a closed-loop control
- with a measurement input adapted to repeatedly receive a measurement value of the gate charging current or of the gate discharging current and
- with a reference input adapted to receive a reference value of a current,
wherein the closed-loop control is adapted to control repeatedly switching on and switching off each of the first and second controllable semiconductor switches (23, 24) so that the gate charging current or the gate discharging current is regulated to the reference value.

5. The power converter (11) of one of claims 1 to 4, comprising a first steady state switch that is connected to a connection from the inductance (29) to the gate (13) and is connected to the first voltage potential and wherein the gate driver circuit (12; 12a) is adapted to switch on the first steady state switch in a first switching state of the power semiconductor switch (1), wherein the first switching state is the state the power semiconductor switch (1) assumes when the gate (13) is at the first voltage potential.

6. The power converter (11) of one of claims 1 to 5, comprising a second steady state switch that is connected to a connection from the inductance (29) to the gate (13) and is connected to the second voltage potential and wherein the gate driver circuit (12; 12a) is adapted to switch on the second steady state switch in a second switching state of the power semiconductor switch (1), wherein the second switching state is the state the power semiconductor switch (1) assumes when the gate (13) is at the second voltage potential.

7. A method of operating a power converter (11) comprising:
- a power semiconductor switch (1) with insulated gate (13) that is repeatedly switched on and off to switch a power current which flows through the power semiconductor switch (1),
- a gate driver circuit (12; 12a) that generates a gate charging current for charging the gate (13) and generates a gate discharging current for discharging the gate (13),
wherein the gate driver circuit (12; 12a) is controlled by a controller (20) of the power converter (11) to charge and discharge the gate (13), thereby changing the switching state of the semiconductor switch from on to off or from off to on, **characterized in that** the method is comprising
- by using the controller (20), individually controlling a first and a second controllable semiconductor switch (23, 24) of the gate driver circuit (12; 12a), that are connected in series to each other and therefore form a switch series connection,
- providing electric energy for charging and discharging the gate (13) from an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end,
- conducting the gate charging current for charging the gate (13) and/or the gate discharging current for discharging the gate (13) through a current path between an intermediate connection of the switch series connection and the gate (13), which intermediate connection is arranged between the first and second controllable semiconductor switch (23, 24),
wherein
- in order to perform a charging process of charging the gate (13), the controller (20) repeatedly switches on and switch off each of the first and second controllable semiconductor switches (23, 24), thereby realizing a charging switching pattern and thereby generating a charging current flowing from the intermediate connection to the gate (13), wherein only one of the first and second controllable semiconductor switches (23, 24) is on at each time during the charging process, and/or
- in order to perform a discharging process of discharging the gate (13), the controller (20) repeatedly switches on and switch off each of the first and second controllable semiconductor switches (23, 24), thereby realizing a discharging switching pattern and thereby generating a discharging current flowing from the gate (13) to the intermediate connection, wherein only one of the first and second controllable semiconductor switches (23, 24) is on at each time during the discharging process.

8. The method of claim 7, wherein the switching pattern and the inductance (29) are adapted to each other to produce a continuous charging current during the charging process until the switching state of the power semiconductor switch (1) is changed by the charging process.

9. The method of claim 7 or 8, wherein
- the controller (20) accesses a switching pattern storage in which at least one switching pattern of a timing of switching on and switching off the first and second controllable semiconductor switches (23, 24) is stored and
- repeatedly switches on and switches off each of the first and second controllable semiconductor switches (23, 24) according to the accessed charging switching pattern or accessed discharging pattern.

10. The method of one of claims 7 to 9, wherein a closed-loop control of the controller (20)
- repeatedly receives a measurement value of the gate charging current or of the gate discharging current and
- receives a reference value of a current,
wherein the closed-loop control controls repeatedly switching on and switching off each of the first and second controllable semiconductor switches (23, 24) so that the gate charging current or the gate discharging current is regulated to the reference value.

11. The method of one of claims 7 to 10, a first steady state switch that is connected to a connection from the inductance (29) to the gate (13) and is connected to the first voltage potential is switched on in a first switching state of the power semiconductor switch (1), wherein the first switching state is the state the power semiconductor switch (1) assumes when the gate (13) is at the first voltage potential.

12. The power converter (11) of one of claims 1 to 5, a second steady state switch that is connected to a connection from the inductance (29) to the gate (13) and is connected to the second voltage potential is switched on in a second switching state of the power semiconductor switch (1), wherein the second switching state is the state the power semiconductor switch (1) assumes when the gate (13) is at the second voltage potential.

## Amended claims

### Amended claims in accordance with Rule 137(2) EPC.

1. A power converter (11) comprising:
- a power semiconductor switch (1) with insulated gate (13) for repeatedly switching on and off a power current that flows through the power semiconductor switch (1),
- a gate driver circuit (12; 12a) adapted to generate a gate charging current for charging the gate (13) and to generate a gate discharging current for discharging the gate (13),
- a controller (20) adapted to control the gate driver circuit (12; 12a),
wherein
- the gate driver circuit (12; 12a) comprises a first and a second controllable semiconductor switch (23, 24) that are connected in series to each other to form a switch series connection and that are individually controllable by the controller (20),
- the gate driver circuit (12; 12a) comprises an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end,
- the gate driver circuit (12; 12a) comprises an inductance (29), wherein an intermediate connection of the switch series connection between the first and second controllable semiconductor switch (23, 24) is connected to the gate (13) via the inductance (29),
wherein
- in order to perform a charging process of charging the gate (13), the controller (20) is adapted to repeatedly switch on and switch off each of the first and second controllable semiconductor switches (23, 24), thereby realizing a charging switching pattern and thereby generating a charging current flowing from the intermediate connection to the gate (13), wherein only one of the first and second controllable semiconductor switches (23, 24) may be on at each time during the charging process, and/or
- in order to perform a discharging process of discharging the gate (13), the controller (20) is adapted to repeatedly switch on and switch off each of the first and second controllable semiconductor switches (23, 24), thereby realizing a discharging switching pattern and thereby generating a discharging current flowing from the gate (13) to the intermediate connection, wherein only one of the first and second controllable semiconductor switches (23, 24) may be on at each time during the discharging process,
**characterized in that**.
the controller (20) comprises a closed-loop control
- with a measurement input adapted to repeatedly receive a measurement value of the gate charging current or of the gate discharging current and
- with a reference input adapted to receive a reference value of a current,
wherein the closed-loop control is adapted to control repeatedly switching on and switching off each of the first and second controllable semiconductor switches (23, 24) so that the gate charging current or the gate discharging current is regulated to the reference value.

2. The power converter (11) of claim 1, wherein the switching pattern and the inductance (29) are adapted to each other to produce a continuous charging current during the charging process until the switching state of the power semiconductor switch (1) is changed by the charging process.

3. The power converter (11) of claim 1 or 2, wherein
- the controller (20) is combined with a switching pattern storage in which at least one switching pattern of a timing of switching on and switching off the first and second controllable semiconductor switches (23, 24) is stored and
- the controller (20) is adapted to access the switching pattern storage and is adapted to repeatedly switch on and switch off each of the first and second controllable semiconductor switches (23, 24) according to the accessed charging switching pattern or accessed discharging pattern.

4. The power converter (11) of one of claims 1 to 3, comprising a first steady state switch that is connected to a connection from the inductance (29) to the gate (13) and is connected to the first voltage potential and wherein the gate driver circuit (12; 12a) is adapted to switch on the first steady state switch in a first switching state of the power semiconductor switch (1), wherein the first switching state is the state the power semiconductor switch (1) assumes when the gate (13) is at the first voltage potential.

5. The power converter (11) of one of claims 1 to 4, comprising a second steady state switch that is connected to a connection from the inductance (29) to the gate (13) and is connected to the second voltage potential and wherein the gate driver circuit (12; 12a) is adapted to switch on the second steady state switch in a second switching state of the power semiconductor switch (1), wherein the second switching state is the state the power semiconductor switch (1) assumes when the gate (13) is at the second voltage potential.

6. A method of operating a power converter (11) comprising:
- a power semiconductor switch (1) with insulated gate (13) that is repeatedly switched on and off to switch a power current which flows through the power semiconductor switch (1),
- a gate driver circuit (12; 12a) that generates a gate charging current for charging the gate (13) and generates a gate discharging current for discharging the gate (13),
wherein the gate driver circuit (12; 12a) is controlled by a controller (20) of the power converter (11) to charge and discharge the gate (13), thereby changing the switching state of the semiconductor switch from on to off or from off to on,
the method is comprising
- by using the controller (20), individually controlling a first and a second controllable semiconductor switch (23, 24) of the gate driver circuit (12; 12a), that are connected in series to each other and therefore form a switch series connection,
- providing electric energy for charging and discharging the gate (13) from an electric energy source, wherein opposite poles of the electric energy source at a first and at a second voltage potential are connected to the switch series connection, wherein the first voltage potential is connected to a first end of the switch series connection and the second voltage potential is connected to a second end of the switch series connection that is opposite to the first end,
- conducting the gate charging current for charging the gate (13) and/or the gate discharging current for discharging the gate (13) through a current path between an intermediate connection of the switch series connection and the gate (13), which intermediate connection is arranged between the first and second controllable semiconductor switch (23, 24),
wherein
- in order to perform a charging process of charging the gate (13), the controller (20) repeatedly switches on and switch off each of the first and second controllable semiconductor switches (23, 24), thereby realizing a charging switching pattern and thereby generating a charging current flowing from the intermediate connection to the gate (13), wherein only one of the first and second controllable semiconductor switches (23, 24) is on at each time during the charging process, and/or
- in order to perform a discharging process of discharging the gate (13), the controller (20) repeatedly switches on and switch off each of the first and second controllable semiconductor switches (23, 24), thereby realizing a discharging switching pattern and thereby generating a discharging current flowing from the gate (13) to the intermediate connection, wherein only one of the first and second controllable semiconductor switches (23, 24) is on at each time during the discharging process,
**characterized in that**.
a closed-loop control of the controller (20)
- repeatedly receives a measurement value of the gate charging current or of the gate discharging current and
- receives a reference value of a current,
wherein the closed-loop control controls repeatedly switching on and switching off each of the first and second controllable semiconductor switches (23, 24) so that the gate charging current or the gate discharging current is regulated to the reference value.

7. The method of claim 6, wherein the switching pattern and the inductance (29) are adapted to each other to produce a continuous charging current during the charging process until the switching state of the power semiconductor switch (1) is changed by the charging process.

8. The method of claim 6 or 7, wherein
- the controller (20) accesses a switching pattern storage in which at least one switching pattern of a timing of switching on and switching off the first and second controllable semiconductor switches (23, 24) is stored and
- repeatedly switches on and switches off each of the first and second controllable semiconductor switches (23, 24) according to the accessed charging switching pattern or accessed discharging pattern.

9. The method of one of claims 6 to 8, wherein a closed-loop control of the controller (20)
- repeatedly receives a measurement value of the gate charging current or of the gate discharging current and
- receives a reference value of a current,
wherein the closed-loop control controls repeatedly switching on and switching off each of the first and second controllable semiconductor switches (23, 24) so that the gate charging current or the gate discharging current is regulated to the reference value.

10. The method of one of claims 6 to 9, wherein a first steady state switch that is connected to a connection from the inductance (29) to the gate (13) and is connected to the first voltage potential is switched on in a first switching state of the power semiconductor switch (1), wherein the first switching state is the state the power semiconductor switch (1) assumes when the gate (13) is at the first voltage potential.

11. The method of one of claims 6 to 10, wherein a second steady state switch that is connected to a connection from the inductance (29) to the gate (13) and is connected to the second voltage potential is switched on in a second switching state of the power semiconductor switch (1), wherein the second switching state is the state the power semiconductor switch (1) assumes when the gate (13) is at the second voltage potential.
